# EUROPÄISCHE PATENTANMELDUNG

(11) **EP 1 538 498 A2**
(43) Veröffentlichungstag der Anmeldung: **08.06.2005**
(21) Anmeldenummer: 04104698.8
(22) Anmeldetag: 27.09.2004
(51) Int. Cl.: G05B 19/042

(54) **Adressdecoder und Verfahren zur Adressdecodierung**

(30) Priorität: 22.11.2003 DE 10354665
(71) Anmelder: ROBERT BOSCH GMBH, 70442 Stuttgart (DE)
(72) Erfinder: Kostorz, Wolfgang, 71263, Weil Der Stadt (DE)

(57) **Zusammenfassung**

Die vorliegende Erfmdung stellt einen Adressdecoder (10) bereit mit: einer beschreibbaren Speichereinrichtung (11'), welche mit einem Datenbussignal (24) gekoppelt ist, zum Speichern zumindest eines Datums (12') des Datenbussignals (24); einer Vergleichseinrichtung (13), welche mit der Speichereinrichtung (11') und einem Adresssignal (14) gekoppelt ist, zum Vergleichen des in der Speichereinrichtung (11') gespeicherten Datums (12') mit einer Adresse des Adresssignals (14) und zum Ausgeben eines entsprechenden Vergleichsergebnisses (15); und einer Logikeinrichtung (16) zum Verknüpfen eines externen Steuersignals (17) und des Vergleichsergebnisses (15) und zum Bereitstellen eines Ansteuersignals (18) als Ausgangssignal des Adressdecoders (10) zum Ansteuern zumindest einer elektronischen Einrichtung (21, 22, 23) in Abhängigkeit des externen Steuersignals (17) und des Vergleichsergebnisses (15). Die vorliegende Erfindung stellt ebenfalls ein Verfahren zur Adressdecodierung bereit.

## Beschreibung

### STAND DER TECHNIK

Die vorliegende Erfindung betrifft einen Adressdecoder und ein Verfahren zur Adressdecodierung, und insbesondere ein Mikrocontroller-System mit einem Adressdecoder.

Adressdecoder, z.B. für Mikrocontroller-Systeme, kommen heutzutage zum Einsatz, wenn externe Baugruppen oder Bausteine über einen Adress-/Daten-Bus an ein Mikrocontroller-System angeschlossen werden. Um die Bausteine eindeutig und definiert ansprechen zu können, werden Ansteuersignale für den entsprechenden Baustein nur innerhalb eines vorbestimmten Adressbereichs generiert. Diese Aufgabe kommt einem Adressdecoder zu, welcher in der Regel als Datum eine fest eingestellte Adresse aufweist, d.h. ein externer Baustein bekommt eine feste Adresse zugewiesen.

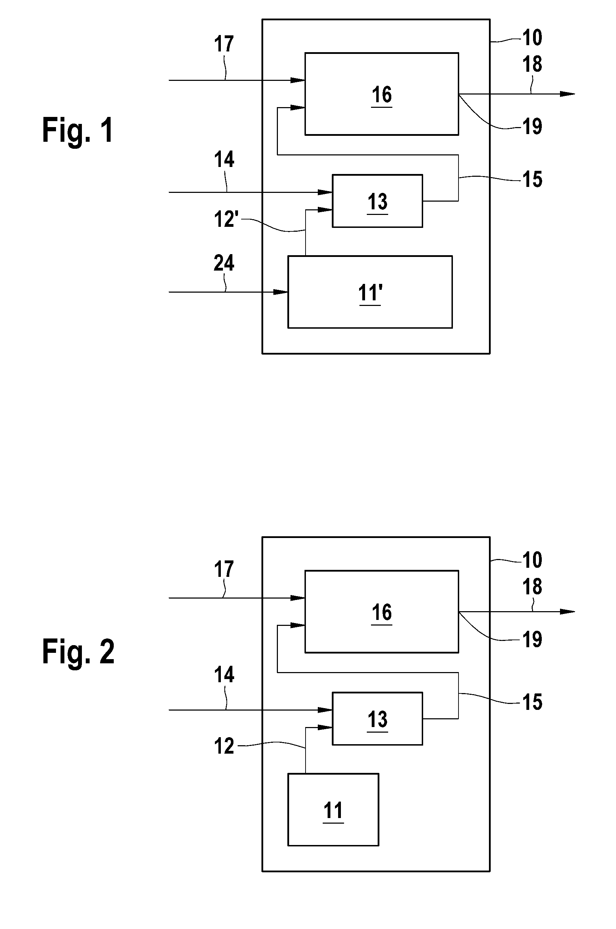

In FIG. 2 ist ein bekannter Adressdecoder 10 dargestellt, welcher eine Speichereinrichtung 11 aufweist, die nicht umprogrammierbar ist. Das nicht umprogrammierbare Datum 12 der Speichereinrichtung 11 ist ein fester Adresswert, welcher an eine Vergleichseinrichtung 13 angelegt wird. In der Vergleichseinrichtung 13 wird das in der Speichereinrichtung 11 gespeicherte Datum 12 mit einem über einen Adressbus 14 zugeführte Adresssignal verglichen, wobei das Vergleichsergebnis 15 einem Logik-Gatter 16 zugeführt wird. Das Logik-Gatter 16, beispielsweise eine UND-Verknüpfung, verknüpft ein Steuersignal 17, welches dem Adressdecoder 10 ebenso von außen zugeführt wird wie der Adressbus 14, mit dem Vergleichsergebnis 15 der Vergleichseinrichtung 13. Das in der Verknüpfungseinrichtung 16 generierte Ansteuersignal 18 wird über einen Ausgang 19 an eine elektronische Einrichtung (nicht dargestellt), welche angesteuert werden soll, weitergeleitet.

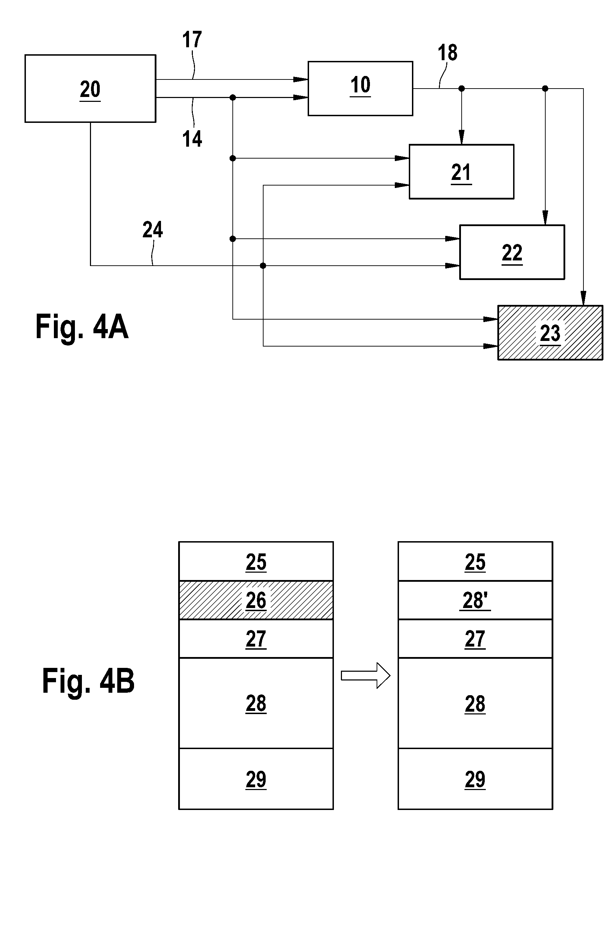

FIG. 4A zeigt eine bekannte Mikrocontroller-Konfiguration, in welcher ein bekannter Adressdecoder 10 gemäß FIG. 2 eingesetzt wird. Ein Mikrocontroller 20 gibt dabei das externe Steuersignal 17 und das Adresssignal 14 an den Adressdecoder 10 aus. Das Adresssignal 14 bzw. der Adressbus wird darüber hinaus über eine Verzweigungsstelle an eine erste, zweite und dritte elektronische Einrichtung 21, 22, 23 geführt, vorzugsweise jeweils eine externe Baugruppe oder ein externer Baustein, welcher über einen Adress-/Datenbus 14, 24 an einen Mikrocontroller 20 angeschlossen ist.

Mit Bezug auf FIG. 4B ist eine Speicherbelegung (memory map) zur Erläuterung der Funktionsweise der bekannten Mikrocontroller-Konfiguration gemäß FIG. 4A in zwei Zuständen dargestellt. Der linke Zustand verdeutlicht die Speicherbelegung bei der Konfiguration gemäß FIG. 4A, wenn alle drei Baugruppen 21, 22, 23 gemäß FIG. 4A eingesetzt sind. Für die erste externe elektronische Einrichtung 21 ist ein erster Speicherbereich 25 vorgesehen. Für die dritte externe Baugruppe 23 ist ein Speicherbereich 26 vorgesehen, wobei für die zweite externe Baugruppe 22 ein zusätzlicher Speicherbereich 27 reserviert ist. Daran schließt sich ein freier Speicherbereich 28 sowie ein mit einem Programm versehener Bereich 29 an.

Im in FIG. 4B rechts dargestellten Speicherbelegungsdiagramm ist der Fall dargestellt, dass die dritte externe Baugruppe 23 gemäß FIG. 4A entfernt wird. An der Speicherbereichsaufteilung ändert sich dabei im Vergleich zur linken Darstellung mit vorhandener dritten Baugruppe 23 nur so viel, dass an der Stelle zwischen dem Speicherbereich 25, 27 der ersten und zweiten externen Baugruppe 21, 22 gemäß FIG. 4A eine Lücke 28' auftritt, d.h. der freie Speicherplatz 28 erweitert sich durch den Wegfall der dritten Baugruppe nicht.

Von Nachteil ist dabei insbesondere bei Systemen mit mehreren externen und vorzugsweise austauschbaren Bausteinen bzw. elektronischen Einrichtungen ähnlich einem PC-Stecksystem, dass diese Art der Adressdecodierung unflexibel ist und der nutzbare Speicherbereich gegebenenfalls in mehrere Abschnitte 28, 28' untergliedert ist, anstatt einen großen zusammenhängenden Speicherbereich zu bilden.

### VORTEILE DER ERFINDUNG

Der erfindungsgemäße Adressdecoder mit den Merkmalen des Anspruchs 1 sowie das erfindungsgemäße Verfahren zur Adressdecodierung mit den Merkmalen des Anspruchs 8 weist gegenüber dem bekannten Lösungsansatz den Vorteil auf, dass durch den programmierbaren Adressdecoder eine flexible Zuordnung eines externen Bausteins bzw. einer externen elektronischen Einrichtung zu einem Speicherbereich bereitgestellt wird. Vorzugsweise zu Beginn eines Programms wird für jeden verfügbaren, externen Baustein der Adressbereich neu vergeben.

Dadurch werden z.B. Mikrocontroller-Systeme variabler Größe ermöglicht, welche eine veränderliche Anzahl von externen Bausteinen/Baugruppen aufweisen. Die Speicherausnutzung wird dadurch maximiert, dass im Speicherbereich keine nicht genutzten Speicherabschnitte zwischen den für die vorhandenen Bausteine vorgesehenen Speicherabschnitte auftreten, d.h. die Lücken minimiert werden.

Die der vorliegenden Erfindung zugrunde liegende Idee besteht im wesentlichen darin, dass der Speicherbereich, in welchem Steuersignale für eine externe Baugruppe generiert werden, programmierbar gestaltet werden. Somit wird insbesondere ein Adressdecoder bereitgestellt mit: einer beschreibbaren Speichereinrichtung, welche mit einem Datenbussignal gekoppelt ist, zum Speichern zumindest eines Datums des Datenbussignals; einer Vergleichseinrichtung, welche mit der Speichereinrichtung und einem Adresssignal gekoppelt ist, zum Vergleichen des in der Speichereinrichtung gespeicherten Datums mit einer Adresse des Adresssignals und zum Ausgeben eines entsprechenden Vergleichsergebnisses; und einer Logikeinrichtung zum Verknüpfen eines Steuersignals und des Vergleichsergebnisses und zum Bereitstellen eines Ansteuersignals als Ausgangssignal des Adressdecoders zum Ansteuern zumindest einer elektronischen Einrichtung in Abhängigkeit des Steuersignals und des Vergleichsergebnisses.

In den Unteransprüchen finden sich vorteilhafte Weiterbildungen und Verbesserungen des im Anspruch 1 angegebenen Adressdecoders und des im Anspruch 8 angegebenen Verfahrens zur Adressdecodierung.

Gemäß einer bevorzugten Weiterbildung weist die Logikeinrichtung eine logische UND-Verknüpfung auf. Eine einfach realisierbare Logikverknüpfung wird auf diese Weise vorteilhaft bereitgestellt.

Gemäß einer weiteren bevorzugten Weiterbildung entspricht das gespeicherte Datum einer Adresse. Somit kann der gespeicherte Adresswert in der Vergleichseinrichtung mit einem über den Adressbuseingang zugeführten Adresswert verglichen werden.

Gemäß einer weiteren bevorzugten Weiterbildung weist die zumindest eine elektronische Einrichtung eine externe elektronische Baugruppe und/oder einen elektronischen Baustein auf. Dies birgt den Vorteil der Ansteuerung einer variablen Anzahl von elektronischen Baugruppen vorteilhaft durch den Adressdecoder.

Gemäß einer weiteren bevorzugten Weiterbildung ist ein Mikrocontroller-System mit einem entsprechenden Adressdecoder mit einem Mikrocontroller vorgesehen, welcher Steuersignale an dem Adressdecoder bereitstellt. Ein Mikrocontroller-System kann auf diese Weise vorteilhaft mit dem erfindungsgemäßen Adressdecoder kombiniert werden.

Gemäß einer weiteren bevorzugten Weiterbildung ist der Mikrocontroller über einen Adressbus mit dem Adressdecoder und zumindest einer externen elektronischen Einrichtung gekoppelt. Folglich kann auf einfache Weise eine Adresse an dem Adressdecoder und der zumindest einen externen elektronischen Einrichtung vorgesehen werden.

Gemäß einer weiteren bevorzugten Weiterbildung ist der Mikrocontroller über einen Datenbus mit dem Adressdecoder und zumindest einer externen elektronischen Einrichtung gekoppelt. Über den Datenbus werden folglich auf vorteilhafte Weise z.B. ein Adresswert in die programmierbare Speichereinrichtung des Adressdecoders eingeschrieben.

Gemäß einer weiteren bevorzugten Weiterbildung wird das Datum bei einem Initialisierungs- und/oder Boot-Vorgang in der Speichereinrichtung gespeichert. Dies birgt den Vorteil einer neuen Speicherbereichseinteilung, abhängig von der Anzahl der elektronischen Einrichtungen bei jedem Hochfahren bzw. Power-up des Systems.

Gemäß einer weiteren bevorzugten Weiterbildung werden die Steuersignale, Adressbussignale und Datenbussignale von einem Mikrocontroller erzeugt. Dies ermöglicht auf vorteilhafte Weise ein effizientes Mikrocontroller-System.

### ZEICHNUNGEN

Ausführungsbeispiele der Erfindung sind in den Zeichnungen dargestellt und in der nachfolgenden Beschreibung näher erläutert.

Es zeigen:
- FIG. 1: ein schematisches Blockschaltbild eines Adressdecoders zur Erläuterung einer Ausführungsform der vorliegenden Erfmdung;
- Fig. 2: ein schematisches Blockschaltbild eines bekannten Adressdecoders;
- FIG. 3A: ein schematisches Blockschaltbild eines Mikrocontroller-Systems mit Adressdecoder zur Erläuterung einer bevorzugten Weiterbildung der vorliegenden Erfindung;
- FIG. 3B: ein schematisches Diagramm zur Erläuterung des Speicherzustands bzw. der Speicherbelegung gemäß einer Ausführungsform der vorliegenden Erfindung;
- FIG. 4A: ein schematisches Blockschaltbild eines bekannten Mikrocontroller-Systems; und
- FIG. 4B: eine schematische Darstellung einer Speicherbelegung der bekannten Anordnung gemäß FIG. 4A.

### BESCHREIBUNG DER AUSFÜHRUNGSBEISPIELE

In den Figuren bezeichnen gleiche Bezugszeichen gleiche oder funktionsgleiche Bestandteile.

In Fig. 1 ist ein Adressdecoder 10 dargestellt, welcher eine umprogrammierbare, beschreibbare Speichereinrichtung 11' aufweist. In der programmierbaren Speichereinrichtung 11' ist ein programmierbares Datum 12', vorzugsweise eine Adresse, speicherbar. Die programmierbare Speichereinrichtung 11' ist mit einer Vergleichseinrichtung 13 gekoppelt, welcher ein Adressbus 15 bzw. ein Adressbussignal zugeht. In der Vergleichseinrichtung wird der in der programmierbaren Speichereinrichtung 11' gespeicherte Adresswert 12' mit einer Adresse des Adresssignals 14 verglichen, und bei Übereinstimmung beider Werte ein positives Vergleichsergebnis 15 an eine Logikeinrichtung 16 weitergegeben. In der Logikeinrichtung 16 wird das Vergleichsergebnis 15 mit einem externen Steuersignal 17 verknüpft. Vorzugsweise wird die Logikeinrichtung 16 durch ein UND-Gatter gebildet. Am Ausgang der Logikeinrichtung 16, welcher ebenfalls den Ausgang 19 des Adressdecoders 10 bildet, ist ein Ansteuersignal 18 für elektronische Einrichtungen (nicht dargestellt) bereitgestellt.

Der programmierbare Decoder 10 vergleicht eine angelegte Adresse des Adresssignals 14 somit mit einem über einen Datenbus 24 vorzugsweise in einer Initialisierungsphase zugeführten und in der Speichereinrichtung 11' gespeicherten Adresse. Die über den Adressbus angelegte Adresse wird mit der Adresse gespeichert in einer Speicherzelle verglichen, welche vorzugsweise beim Hochfahren bzw. Booten des Adressdecoders 10 mit einem aktuellen Wert beschrieben wird.

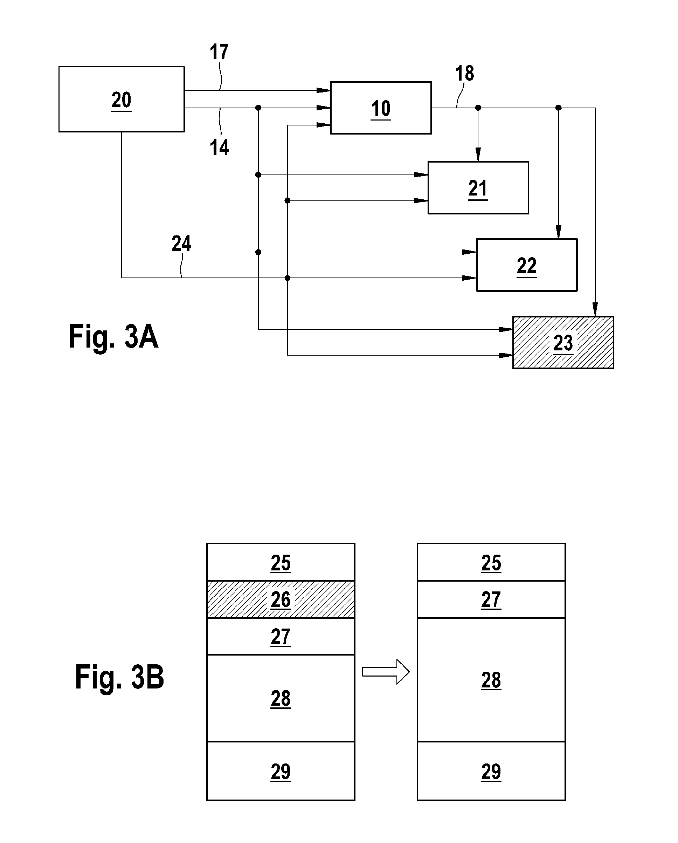

Die Konfiguration gemäß FIG. 3A zeigt einen Adressdecoder 10 gemäß FIG. 1 in einem exemplarischen Mikrocontroller-System. Ein Mikrocontroller 20 gibt dabei über einen Adressbus 14 ein Adressbussignal sowohl an den Adressdecoder 10 als auch an eine erste, zweite und dritte elektronische Einrichtung 21, 22, 23, welche vorzugsweise durch elektronische Bauteile und/oder Baugruppen gebildet werden. Zusätzlich gibt der Mikrocontroller 20 Steuersignale 17 an den Adressdecoder 10 weiter. Über einen Datenbus 24 ist der Mikrocontroller 20 ebenfalls sowohl an den Adressdecoder 10 als auch an die erste, zweite und dritte elektronische Einrichtung 21, 22, 23 gekoppelt. Der Ansteuerausgang 19 des Adressdecoders 10 ist an die erste, zweite und dritte elektronische Einrichtung 21, 22 und 23 gekoppelt. Die Ansteuersignale 18 am Ansteuerausgang 19 des Adressdecoders 10 sind abhängig vom Speicherbereich, welcher jeder externen Baugruppe 21, 22 und 23 zugeordnet ist.

In FIG. 3B ist zur Erläuterung der Funktionsweise der Anordnung gemäß FIG. 3A jeweils ein Speicherbelegungsdiagramm in zwei Zuständen dargestellt. Bei der linken Speicheraufteilung ist jeweils ein Speicherbereich 25, 26 und 27 für die erste, dritte und zweite elektronische Einrichtung 21, 23 und 22 vorgesehen. Daran schließt sich ein freier Speicherbereich 28 an, wobei ebenfalls ein mit einem Programm beaufschlagter Speicherbereich 29 vorhanden ist. Wird nun in der Konfiguration gemäß FIG. 3A die dritte elektronische Einrichtung 23 bzw. Baugruppe entfernt (in FIG. 3A nicht dargestellt), so ist erfindungsgemäß die rechte Speicherbereichsaufteilung in FIG. 3B realisierbar. Der Speicherbereich für die dritte elektronische Einrichtung 23 gemäß FIG. 3A wird nicht vorgesehen, so dass der freie Speicherbereich 28 im Vergleich zur linken Speicheraufteilung vergrößert ist, ohne in zwei freie Speicherbereiche 28, 28' gemäß FIG. 4B eingeteilt zu sein. Der Speicherbereich 25, 26, 27, innerhalb dessen die Ansteuersignale 18 für eine externe Baugruppe 21, 22, 23 erzeugt werden, wird somit nicht fest verdrahtet, sondern programmierbar gestaltet.

Obwohl die vorliegende Erfmdung vorstehend anhand bevorzugter Ausführungsbeispiele beschrieben wurde, ist sie nicht darauf beschränkt, sondern auf vielfältige Weise modifizierbar. So kann der programmierbare Adressdecoder 10 optional auch derart ergänzt werden, dass nicht nur eine Speicherbank, d.h. der obere Teil eines Adressbusses, decodiert wird, sondern der komplette Adressbus mit einer Ober- und Untergrenze verglichen wird. Damit wird eine byte-genaue Aufteilung der Speicherbereiche möglich. In einem solchen Fall ist es erforderlich, pro ansteuerbare elektronische Einrichtung 21, 22, 23 bzw. Baugruppe zwei Grenzen, d.h. eine Ober- und Untergrenze, zu programmieren.

Darüber hinaus besteht die Möglichkeit, den Adressdecoder auch in von einem Mikrocontroller-System gelösten Umfeld einzusetzen. Die Anzahl der angesteuerten elektronischen Einrichtungen 21, 22 und 23 ist beispielhaft zu betrachten, ebenso wie die konkreten Steuersignal-, Adressbus- und Datenbusverbindungen 17, 14 und 24, welche beispielsweise drahtgebunden, über Lichtwellenleiter oder auch drahtlos, beispielsweise mit einer Mikrocontroller-Einrichtung 20, gekoppelt sind.

## Patentansprüche

1. Adressdecoder (10) mit:
einer beschreibbaren Speichereinrichtung (11'), welche mit einem Datenbussignal (24) gekoppelt ist, zum Speichern zumindest eines Datums (12') des Datenbussignals (24);
einer Vergleichseinrichtung (13), welche mit der Speichereinrichtung (11') und einem Adresssignal (14) gekoppelt ist, zum Vergleichen des in der Speichereinrichtung (11') gespeicherten Datums (12') mit einer Adresse des Adresssignals (14) und zum Ausgeben eines entsprechenden Vergleichsergebnisses (15); und
einer Logikeinrichtung (16) zum Verknüpfen eines externen Steuersignals (17) und des Vergleichsergebnisses (15) und zum Bereitstellen eines Ansteuersignals (18) als Ausgangssignal des Adressdecoders (10) zum Ansteuern zumindest einer elektronischen Einrichtung (21, 22, 23) in Abhängigkeit des externen Steuersignals (17) und des Vergleichsergebnisses (15).

2. Adressdecoder nach Anspruch 1,
**dadurch gekennzeichnet,**
**dass** die Logikeinrichtung (16) eine logische UND-Verknüpfung aufweist.

3. Adressdecoder nach Anspruch 1 oder 2,
**dadurch gekennzeichnet,**
**dass** das gespeicherte Datum (12') einer Adresse entspricht.

4. Adressdecoder nach Anspruch 1, 2 oder 3,
**dadurch gekennzeichnet,**
**dass** die zumindest eine elektronische Einrichtung (21, 22, 23) eine externe elektronische Baugruppe und/oder einen externen elektronischen Baustein aufweist.

5. Mikrocontroller-System mit einem Adressdecoder nach einem der vorangehenden Ansprüche,
**dadurch gekennzeichnet,**
**dass** ein Mikrocontroller (20) vorgesehen ist, welcher Steuersignale (17) an dem Adressdecoder bereitstellt.

6. Mikrocontroller-System mit einem Adressdecoder nach Anspruch 5,
**dadurch gekennzeichnet,**
**dass** der Mikrocontroller (20) über einen Adressbus (14) mit dem Adressdecoder (10) und zumindest einer externen elektronischen Einrichtung (21, 22, 23) gekoppelt ist.

7. Mikrocontroller-System mit einem Adressdecoder nach Anspruch 5 oder 6,
**dadurch gekennzeichnet,**
**dass** der Mikrocontroller (20) über einen Datenbus (24) mit dem Adressdecoder (10) und zumindest einer externen elektronischen Einrichtung (21, 22, 23) gekoppelt ist.

8. Verfahren zur Adressdecodierung mit den Schritten:
(a) Speichern eines Datums (12') in einer Speichereinrichtung (11'), welche mit einem Datenbuseingangssignal (24) gekoppelt ist;
(b) Vergleichen des in der Speichereinrichtung (11') gespeicherten Datums (12') mit einer Adresse eines Adressbuseingangssignals (14) in einer Vergleichseinrichtung (13), welche mit der Speichereinrichtung (11') und dem Adressbuseingangssignal (14) gekoppelt ist, und Erzeugen eines entsprechenden Vergleichsergebnisses (15);
(c) Erzeugen eines Ansteuersignals (18) in einer Logikeinrichtung (16) in Abhängigkeit eines externen Steuersignals (17) und des Vergleichsergebnisses (15); und
(d) Ansteuern zumindest einer elektronischen Einrichtung (21, 22, 23) über das Ansteuersignal (19).

9. Verfahren nach Anspruch 8,
**dadurch gekennzeichnet,**
**dass** das Datum (12') bei einem, vorzugsweise bei jedem, Initialisierungs- und/oder Boot-Vorgang in der Speichereinrichtung (11') gespeichert wird.

10. Verfahren nach Anspruch 8 oder 9,
**dadurch gekennzeichnet,**
**dass** Steuersignale (17), Adressbussignale (14) und Datenbussignale (24) von einem Mikrocontroller (20) erzeugt werden.
